# EUROPEAN PATENT SPECIFICATION

(11) **EP 2 374 192 B1**
(45) Date of publication and mention of the grant of the patent: **04.07.2018**
(21) Application number: 09836438.3
(22) Date of filing: 16.12.2009
(51) Int. Cl.: H02J 3/18, H02J 3/38, F03D 9/00, H02P 9/42

(54) **METHOD FOR OPERATION OF A PERMANENT MAGNET SYNCHRONOUS MACHINE, AND A DEVICE IN AN ELECTRIC SYSTEM COMPRISING SUCH A MACHINE**
VERFAHREN FÜR DEN BETRIEB EINER PERMANENTMAGNET-SYNCHRONMASCHINE UND VORRICHTUNG IN EINEM ELEKTRISCHEN SYSTEM MIT DERARTIGER MASCHINE
PROCÉDÉ DE FONCTIONNEMENT D'UNE MACHINE SYNCHRONE À AIMANTS PERMANENTS, ET DISPOSITIF DANS UN SYSTÈME ÉLECTRIQUE COMPRENANT CETTE MACHINE

(30) Priority: 19.12.2008 NO 20085321
(43) Date of publication of application: 12.10.2011
(73) Proprietor: Smartmotor AS, 7415 Trondheim (NO)
(72) Inventor: ÖVERBÖ, Sigurd, N-7600 Levanger (NO); MATVEEV, Alexey, N-7052 Trondheim (NO); SKJELLNES, Tore, N-7014 Trondheim (NO)
(74) Representative: Curo AS
(86) International application number: PCT/NO2009/000436
(87) International publication number: WO 2010/077145

(56) References cited:
- EP-A2- 1 343 247
- WO-A1-2007/027141
- DE-A1- 10 210 164
- DE-A1- 19 651 364
- US-A1- 2005 200 337
- US-B1- 6 411 067
- BAUER P ET AL: "EVALUATION OF ELECTRICAL SYSTEMS FOR OFFSHORE WINDFARMS", CONFERENCE RECORD OF THE 2000 IEEE INDUSTRY APPLICATIONS CONFERENCE. 35TH IAS ANNUAL MEETING AND WORLD CONFERENCE ON INDUSTRIAL APPLICATIONS OF ELECTRICAL ENERGY. ROME, ITALY, OCT. 8 - 12, 2000; [CONFERENCE RECORD OF THE IEEE INDUSTRY APPLICATIONS CO, vol. CONF. 35, 8 October 2000 (2000-10-08) , pages 1416-1423, XP001043245, DOI: 10.1109/IAS.2000.882070 ISBN: 978-0-7803-6402-8

## Description

The invention comprises a method for operation of a permanent magnet synchronous machine as stated in the introductory part of claim 1, and a device as stated in the introductory part of claim 6, in an electric system comprising one or more such machines.

### Background

Current proposals for feeding and control of electric machines are dominated by three-phase feeding. The connection may be direct or via a converter. In some cases the rotor is feed by collector rings and converter.

Usual prior art systems with field fed synchronous machines (Electric Machines, Theory, Operation, Applications, Adjustment, and Control, Charles I Hubert. ISBN 0-675-21136-0, page 305 - 308) has a fixed grid frequency. In such systems the active power and the reactive power may be controlled. In generator systems the power is controlled by controlling the energy supplied (wind, water, gas, steam, etc.). The reactive power is controlled by controlling the current of the field winding. At over magnetizing reactive power is fed into the system, which is normally increasing the voltage (provided inductive load angle). At too low magnetizing, reactive power from the grid, with inductive load angle the voltage will decrease. In usual synchronous machines, a magnetizing machine and an auxiliary motor (same source) is used. The magnetizing machine provides collector less transfer of the magnetizing current. The auxiliary motor (starting motor) is running the machine to synchronous rotation. It is possible to combine the magnetizing machine and the auxiliary motor as described in PCT application WO 85/02886.

In modern permanent magnet synchronous machine (PMSM) systems converters are normally used for connecting the machine to the grid. The converter provides a decoupling between grid and machine which allows operation at variable rotation. The converter allows control toward the net. This "active front end" may use switches instead for diodes toward the net. This configuration provides a currently satisfactory grid connection. The drawback is the costs of the converter which in some cases is equal to the machine cost.

During the last decades, systems have been proposed with partial converter feeding to provide increased functionality. An example is the double fed asynchronous machine shown in Electric Machines, Theory, Operation, Applications, Adjustment, and Control, Charles I Hubert. ISBN 0-675-21136-0, Chapter 8. The stator is fed directly from the grid, while the rotor is fed via a converter and collector rings. This configuration provides increased functionality with only 1/3 converter rating. It is known multi-phase asynchronous machines and reluctance machines connected to the grid through a double feed of the stator. Another example of prior art technology is the synchronous machine with a stator connected directly to the grid, while the field circuit has a converter. Also the converter has a power rating substantially less than the nominal rating of the generator. On slower rotating machines, conventional synchronous machines will require unsuitable large diameter to accommodate the magnetizing windings. In such cases a permanent magnet synchronous machine (PMSM) is a favorable alternative. The drawback of PMSM machines is that the field cannot be controlled with a field winding and a converter rated for the whole machine power is needed to control it. In some applications PMSM machines are connected directly to the grid and are operated as motor or generator. This configuration may be used in a system with a stable speed. Due to the fixed voltage/speed curve of the PM machine, the flow of reactive power cannot be controlled in such systems. An alternative control for such systems is to install a parallel source of reactive power. Such sources can be established with staged static condensers or switched condenser assemblies (STATCOM). The drawback of such systems is the high costs.

"Soft Starter" is a notion used for systems with devices for providing a better start in regard of start current and transient torque (Design of Intelligent Soft-Start Controller for Induction Motor, Wen-Xiong Li, Jian-Guo Lv, Ming-Sheng Lw., Proceedings of the Third International Conference on Machine learning and Cybernetics, Shanghai, 26-29 august 2004). Typical for such systems is the use of thyristors connected in series to the stator winding. The thyristors are ramping up the voltage to the stator, to provide a softer start than at direct starting. This type of equipment cannot give the functionality as a full bridge converter regarding torque/speed control when starting. Serial connected thyristors provide less control than a full bridge configuration, which by use of advanced vector control can control all kinds of machines optimally. Serial connection of thyristors has also been proposed to control active and reactive power.

From EP1343247 A2 it is known a turbine generating apparatus comprising a turbine generator including a gas turbine capable of controlling an output thereof by a fuel flow rate and a permanent magnet type synchronous generator connected to said gas turbine, where the permanent magnet synchronous generator is connected to a grid via a converter rated at full power.

Other prior art shows PMSM machines connected to the grid with the possibility to connect a converter configuration on to the grid connection and possibly disconnects the grid connection entirely. Such solutions can be found in ABB Research's WO2007027141A1 patent application from 08.03.2007. The drawback of such systems is that the voltage levels on the converter must be the same as the grid without using a transformer.

### Objects

The main object of the invention is to reduce costs and size, with a machine occupying less space than a corresponding permanent magnet synchronous machine.

It is also an object to provide a system with a higher efficiency compared with system with full converter.

Further objects will appear from the following description of the invention and its embodiments.

### The Invention

The method according to the invention is described in claim 1. It is based on double feeding of the stator of a permanent magnet synchronous machine. The double feeding is achieved by using the combination of a direct feeding and a converter unit feeding of a stator, where at least one of the winding groups is permanently connected to a grid via the converter unit and at least one other winding group is selectively connected to the grid via a connector. This provides more advantages compared to prior art technology. The advantages of different machine types are stated more specifically in the following examples. The invention may be called "double fed permanent magnet synchronous machine" (DFPMSM).

The invention also comprises a device in an electric system including a permanent magnet synchronous machine, as stated in claim 6. It comprises a device in a system with a permanent magnet synchronous machine, such as a motor or a generator, with a converter unit for feeding or withdrawal of power, the novelty being the converter unit being arranged to feed or withdraw a power substantially lower than the maximum power, that the machine comprises more than one winding group, and that at least one winding group is selectively connected to a grid via the converter unit and at least one other winding group is selectively connected to the grid via a connector.

This system has corresponding advantages as the method described.

Further features of the invention are described in the remaining claims.

The converter unit may be rated for less than approximately 50% of the total power (nominal power).

The invention may be used with different permanent magnet machines, both rotational and linear, motors as well as generators.

Permanent magnet synchronous machines today are thus connected directly to the grid or connected over a full converter unit (with the nominal power of the machine). By combining both kinds of connection of the stator, it is possible to have a solution operating at constant velocity with control of the reactive power flow. The difference between the prior art and the novel solution is that the double feeding of the prior art systems feeds the same stator windings directly or via a converter unit, while the novel invention has a feeding to separate winding groups.

The novel system has reduced costs compared to a full converter solution, but will provide a substantial part of the same functionality. Additionally to controlling the reactive power supply, the converter unit may be used for controlling the torque. This novel solution has no brushes or collector rings and will thus need substantially less maintenance than prior art systems like Double Fed Induction Generator (DFIG).

The size of the converter unit fed part will vary according to the requirements for control of the system. The requirements for coupling vary from country to country. In Norway, the proprietor of the grid is issuing the requirements. In the advice for grid connection, systems larger than 10 MW have particular connection requirements. These requirements imply that novel systems should be designed to contribute to control the active and reactive power during different conditions of operation in the grid.

For such systems the requirement for the converter unit fed part of the system reaches 50 %. For smaller systems (< 10 MW), the invention will make the system more resistant to malfunction of the system. On voltage changes, the system may deliver reactive power to the grid. For smaller system (< 10 MW) the requirements of the grid proprietor will not guide the system design. In such systems the requirement for stable voltage will be most important. If one or more generator systems provide a voltage changes or frequency changes exceeding the limits for the output quality, the power supplier will be responsible for possible damage to the electric system. At the consumer side, damage occurs to equipment normally when the voltage is too high or too low. When using conventional permanent magnet synchronous generators, the terminal voltage of the generator system is controlled, to avoid damages at the consumer side.

The converter unit to be used according to the invention may be a standard converter unit. There is no limitation to the type of switches or topologies to be used. One example may be a full bridge converter unit. This converter unit may be based on IGBT (Insulated Gate Bipolar Transistor) technology and be designed with a part for the grid side (Active Front End) and a part connected to the motor. Said two converter unit parts are typically connected with a DC connection.

### Example

The invention is now described with reference to the drawing.

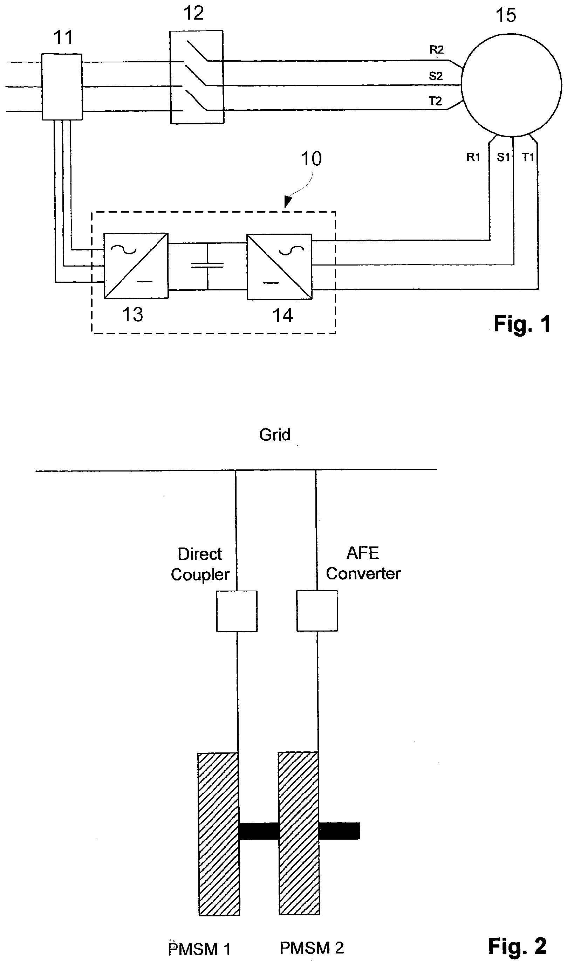

### Description to Figure 1

An integrated solution is shown in Figure 1. R1, R2, S1, S2, T1, and T2 denote windings connected to two separate zero points. The windings are grouped to make each group a three phase system. Group 1 consists of R1, S1, T1. Group 2 consists of R2, S2, T2. Group 1 is connected to the grid through a converter unit 10. Group 2 is connected directly to the grid through a grid connector 12. When the machine is started the rotor is accelerated with the converter unit 10. It is possible to use the converter unit 10 controlled part for operating at changing speeds. This may be useful in a wind power system when withdrawing a reduced power at low speeds, or in a propeller system with pitch control.
11 denotes a connector between the direct connection and the converter unit 10. It may contain grid filters and/or transformers.
12 denotes a connector for making a direct connection. It may be mechanical (a contactor) or electronical (power electronics),
13 denotes a AC-DC converter inside the converter unit 10 that is connected to the grid,
14 denotes a DC-AC converter inside the converter unit 10 that is connected to the electric machine,
15 denotes an electric machine.

### Description to Figure 2

In Figure 2 a system is shown with two machines on the same shaft. This principle can also be used in systems without a common shaft for starting an engine with an alternative admission (e.g. water or steam).

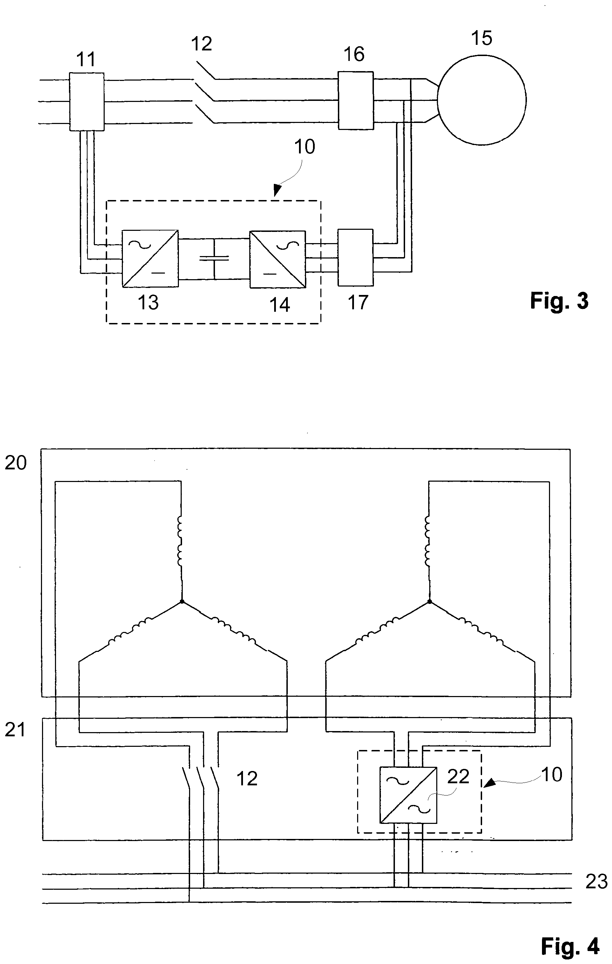

### Description to Figure 3

11 denotes a connector between the direct connection and the converter unit 10. It may contain grid filters and/or transformers.
12 denotes a connector for making a direct connection. It may be physical (a contactor) or electronically (power electronics),
13 denotes a AC-DC converter inside a converter10 unit connected to the grid,
14 denotes a DC-AC converter inside a converter unit 10 connected to the electric machine,
15 denotes an electric machine,
16 denotes a filter or a transformer (may also be operated without),
17 denotes a filter or a transformer (may also be operated without).

The connection assembly shown in Figure 3 is according to prior art. The converters 13, 14 of the converter unit 10 of Figure 3 may be common full bridge converters or other converter concepts, e.g. a multi-level converter. Converters with switches that can close independently are favorable, e.g. IGBT switches.

In Figure 3 the converters are connected over the direct connection via a filter or grid transformer. The filter may be L or LCL for this kind of system. The rating of the filter together with the converter will govern the part of the power to be controlled.

By using the converter unit 10, the reactive and the active power may be controlled. The system may also be controlled without disturbance of the grid. If only the direct connection is used, maximum efficiency may be achieved for some operation modes.

The last solution is optimal in regard of efficiency, as the system may deliver full power without using the converter unit 10. The converter unit 10 mode of operation may be changed between passive, synchronizing, starting, stopping, reactive compensator and more.

The operation with optimum efficiency is particularly important when generating power, but also important in systems with high cooling requirements. This may be the case in downhole operation with high surface temperatures. With the system of Figure 3, a system may be provided using power electronics during start and operation to reduce the losses.

The embodiment of Figure 3 does not form a part of the present invention, but is included as it is useful for understanding the present invention.

### Description to Figure 4

Figure 4 shows an alternative to the electric system of Figure 1.
20 denotes a stator of an electric machine (6 phase),
21 denotes a connection to a grid,
12 denotes a direct connection,
22 denotes a frequency converter of the converter unit 10,
23 denotes a grid.

Figure 4 is a schematically illustration of a double fed stator. The stator 1 has 6 phases. Three of the phases are connected to the direct connection 12, while three of the phases are connected to the converter unit 10. Both supplies are connected to the grid 23 to have the stator double fed. Additionally the system may also have filters and transformers. Contactors may be arranged to allow bypass and/or parallel connection of the converter.

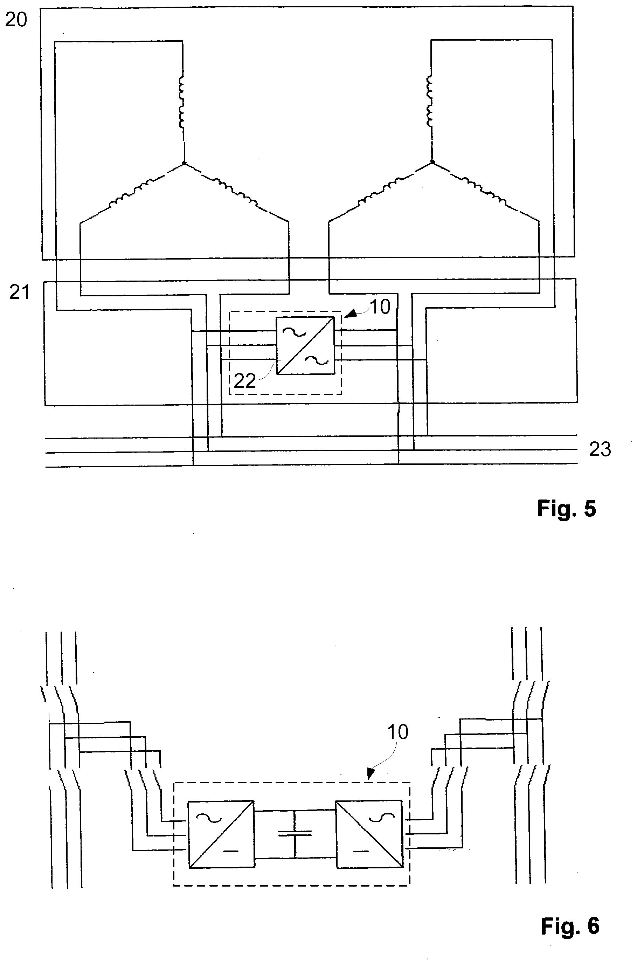

### Description to Figures 5 and 6

20 denotes a stator of an electric machine (6 phase),
12 denotes a connection to a grid,
22 denotes a frequency converter of the converter unit 10,
23 denotes a grid.

Figure 5 is showing an alternative connection of the double fed system. In this case, the converter is connected between the two separate sets of windings. Figure 6 is showing a possible connection for the converter in Figure 5. The configuration in Figures 5 and 6 will allow all advantages of a double feeding (start, braking, reactive power control, damping of transients etc.).

The embodiments of Figure 5 and 6 do not form a part of the present invention, but is included as they are useful for understanding the present invention.

### Configurations/Modifications

The system may be structured differently:

### Integrated solution

In the integrated solutions, a machine may be split in different groups of windings. Each group is representing a three phase connection. One or more groups may be direct fed, while one or more may have a converter connection. An electric machine may be arranged with multiple three phase systems, e.g. a 9 phase system, with 3 phases connected via a converter and 6 phases connected direct.

### Systems solutions

In one system one may use a physically decoupled system, where some parts are connected directly to the grid, while one or more parts are connected over a converter. The system control may be provided to control the power flow through the converter and the physical admission.

### Examples of use

The invention may be used at a generator system powered by water or other kinds of energy. For one generator system, there may be multiple possibilities for dividing the system in a direct connected part and a converter connected part.

In electrical motors it is possible to use the converter part to bring the machine to a synchronous speed. When the speed is synchronous, the part for direct connection is connected. The system is operating like prior art synchronous machines with an auxiliary machine to achieve synchronous speed. The difference is the use of double fed windings of a stator of a PM machine. An example of this kind of system may be the propulsion system of a ship. In some systems the propellers are having a constant speed and adjustment of the deflection of the propeller blade. This type of system may be started with propellers of zero deflection with the converter and some of the windings. When the machine has a synchronous speed, then the part to be direct connected is engaged. In this way less expensive and more efficient propulsion is achieved.

A further version of this invention is used for double fed linear PSM machines. Generally this may provide the same advantages as described for rotating PMSM machines. This is further described with an example.

Linear machines are used in different markets and applications. One example is linear systems with a spring in each end, wherein resonance is involved. Such resonance systems are used for multiple applications. Common to some of these applications is the need for accelerating the system to the resonance velocity. When this velocity is achieved, the work or operation is conducted at this velocity. The invention with double fed stator may e.g. be used at linear machines with a frequency converter for starting. At the resonance frequency, the double fed windings are connected. The converter fed windings may provide control to the machine, together with control of the reactive power against the grid.

### Summary of the advantages of the invention

- When lines are down, the novel system may operate independently
- The active power can be controlled at substantially lower costs
- The reactive power can be controlled at substantially lower costs
- It is possible to change between direct and converter feeding
- The invention may be used with multiple stators on a common shaft
- The invention may be used in systems with multiple machines, where one machine is converter fed and the remaining direct fed
- Double feeding may be used for lowering the losses.

The invention allows the replacing of a normal synchronous machine with a double fed permanent magnet synchronous machine.

## Claims

1. Method for operating a permanent magnet synchronous machine (15), having more than one winding groups, and where a converter unit (10) is connected to stator of the permanent magnet synchronous machine (15), **characterized by** connecting at least one winding group (R1, S1, T1) to a grid via the converter unit (10) and connecting at least one other winding group (R2, S2, T2) selectively directly to the grid via a connector (12).

2. Method according to claim 1, **characterized in that** the power of the converter unit (10) is less than about 50% of the total power.

3. Method according to claim 1 or 2, **characterized in that** the converter unit (10) is used for starting the permanent magnet synchronous machine (15).

4. Method according to one of the claims 1 to 3, **characterized in that** the converter unit (10) is used to control active and reactive flow of power and for frequency control of the permanent magnet synchronous machine (15).

5. Method according to one of the claims 1 to 3, **characterized in that** the converter unit (10) is used for damping transients corresponding to the damping windings in prior art synchronous machines.

6. A system with a permanent magnet synchronous machine (15), as a motor or a generator, with a converter unit (10) for feeding or withdrawal of power, the converter unit (10) is connected to stator of the permanent magnet synchronous machine (15), wherein the permanent magnet synchronous machine (15) has more than one winding group, **characterized in that**
- the converter unit (10) is arranged for feeding or withdrawal of substantially less power than the maximum power of the system, and
- at least one winding group (R1, S1, T1) is connected to a grid via the converter unit (10) and at least one other winding group (R2, S2, T2) is configured to be selectively connected to the grid via a connector (12).

7. System according to claim 6, **characterized in that** the winding groups of the permanent magnet machine (15) is defined by segments of the machine, disks or dishes of the machine, separate machines or windings connected to different neutral points.

8. System according to claim 6, **characterized in that** the converter unit (10) is rated for less than about 50 % of the total power.

## Patentansprüche

1. Verfahren zum Betätigen einer permanenterregten Synchronmaschine (15) mit mehr als einer Wicklungsgruppe, und wo eine Konvertereinheit (10) mit einem Stator der permanenterregten Synchronmaschine (15) verbunden ist, **gekennzeichnet durch** Verbinden mindestens einer Wicklungsgruppe (R1, S1, T1) mit einem Stromnetz über die Konvertereinheit (10) und selektives direktes Verbinden mindestens einer anderen Wicklungsgruppe (R2, S2, T2) mit dem Stromnetz über einen Verbinder (12).

2. Verfahren nach Anspruch 1, **dadurch gekennzeichnet, dass** die Leistung der Konvertereinheit (10) weniger als etwa 50 % der Gesamtleistung beträgt.

3. Verfahren nach Anspruch 1 oder 2, **dadurch gekennzeichnet, dass** die Konvertereinheit (10) zum Starten der permanenterregten Synchronmaschine (15) verwendet wird.

4. Verfahren nach einem der Ansprüche 1 bis 3, **dadurch gekennzeichnet, dass** die Konvertereinheit (10) zur Steuerung eines aktiven und eines reaktiven Leistungsflusses und für die Frequenzsteuerung der permanenterregten Synchronmaschine (15) verwendet wird.

5. Verfahren nach einem der Ansprüche 1 bis 3, **dadurch gekennzeichnet, dass** die Konvertereinheit (10) zum Dämpfen von Transienten verwendet wird, entsprechend den Dämpfungswicklungen in Synchronmaschinen des Standes der Technik.

6. System mit einer permanenterregten Synchronmaschine (15) als Motor oder als Generator, mit einer Konvertereinheit (10) zum Einspeisen oder Entnehmen von Leistung, wobei die Konvertereinheit (10) mit einem Stator der permanenterregten Synchronmaschine (15) verbunden ist, wobei die permanenterregte Synchronmaschine (15) mehr als eine Wicklungsgruppe aufweist, **dadurch gekennzeichnet, dass**
die Konvertereinheit (10) zum Einspeisen oder Entnehmen von Leistung ausgelegt ist, die weit unter der maximalen Leistung des Systems liegt, und
mindestens eine Wicklungsgruppe (R1, S1, T1) über die Konvertereinheit (10) mit einem Stromnetz verbunden ist und mindestens eine andere Wicklungsgruppe (R2, S2, T2) dafür ausgelegt ist, über einen Verbinder (12) selektiv mit dem Stromnetz verbunden zu werden.

7. System nach Anspruch 6, **dadurch gekennzeichnet, dass** die Wicklungsgruppen der permanenterregten Maschine (15) durch Segmente der Maschine, Scheiben oder Platten der Maschine, separate Maschinen oder Wicklungen, die mit unterschiedlichen Sternpunkten verbunden sind, definiert sind.

8. Vorrichtung nach Anspruch 6, **dadurch gekennzeichnet, dass** die Konvertereinheit (10) eine Nennleistung von weniger als etwa 50 % der Gesamtleistung hat.

## Revendications

1. Procédé destiné à la mise en oeuvre d'une machine synchrone à aimants permanents (15), présentant plus d'un groupe d'enroulements et où une unité de convertisseur (10) est connectée au stator de la machine synchrone à aimants permanents (15), **caractérisée en ce qu'**il connecte au moins un groupe d'enroulements (R1, S1, T1) à un réseau par l'intermédiaire de l'unité de convertisseur (10) et connecte au moins un autre groupe d'enroulements (R2, S2, T2) directement au réseau de manière sélective par l'intermédiaire d'un connecteur (12).

2. Procédé selon la revendication 1, **caractérisé en ce que** la puissance de l'unité de convertisseur (10) est inférieure à environ 50 % de la puissance totale.

3. Procédé selon la revendication 1 ou 2, **caractérisé en ce que** l'unité de convertisseur (10) est destinée au démarrage de la machine synchrone à aimants permanents (15).

4. Procédé selon l'une des revendications 1 à 3, **caractérisé en ce que** l'unité de convertisseur (10) est destinée à commander le flux de puissance active et réactive et destinée à commander la fréquence de la machine synchrone à aimants permanents (15).

5. Procédé selon l'une des revendications 1 à 3, **caractérisé en ce que** l'unité de convertisseur (10) est destinée aux transitoires d'amortissement correspondant aux enroulements d'amortissement dans l'état de la technique des machines synchrones.

6. Système comportant une machine synchrone à aimants permanents (15), comme un moteur ou un générateur, comportant une unité de convertisseur (10) destinée à l'alimentation ou au retrait de puissance, l'unité de convertisseur (10) est connectée au stator de la machine synchrone à aimants permanents (15), dans lequel la machine synchrone à aimants permanents (15) présente plus d'un groupe d'enroulements, **caractérisé en ce que**
- l'unité de convertisseur (10) est agencée pour l'alimentation ou le retrait de sensiblement moins de puissance que la puissance maximale du système, et
- au moins un groupe d'enroulements (R1, S1, T1) est connecté à un réseau par l'intermédiaire de l'unité de convertisseur (10) et au moins un autre groupe d'enroulements (R2, S2, T2) est conçu pour être connecté de manière sélective au réseau par l'intermédiaire d'un connecteur (12).

7. Système selon la revendication 6, **caractérisé en ce que** les groupes d'enroulements de la machine à aimants permanents (15) sont définis par des segments de la machine, des disques ou des plateaux de la machine, des machines séparées ou des enroulements connectés à différents points neutres.

8. Système selon la revendication 6, **caractérisé en ce que** l'unité de convertisseur (10) présente une valeur nominale inférieure à environ 50 % de la puissance totale.
